(19) [European Patent Office logo] Europäisches Patentamt / European Patent Office / Office européen des brevets

(11) **EP 2 626 916 B1**

(12) **EUROPEAN PATENT SPECIFICATION**

(45) Date of publication and mention
of the grant of the patent:
**09.03.2016 Bulletin 2016/10**

(21) Application number: **10809126.5**

(22) Date of filing: **30.12.2010**

(51) Int Cl.:
*H01L 33/20* (2010.01)          *H01L 33/58* (2010.01)

(86) International application number:
**PCT/CN2010/080496**

(87) International publication number:
**WO 2011/143919 (24.11.2011 Gazette 2011/47)**

(54) **LIGHT EMITTING DIODE AND MANUFACTURING METHOD THEREOF**

LICHTEMITTIERENDE DIODE UND HERSTELLUNGSVERFAHREN DAFÜR

DIODE ÉLECTROLUMINESCENTE, ET PROCÉDÉ DE FABRICATION CORRESPONDANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.11.2010 CN 201010530988**

(43) Date of publication of application:
**14.08.2013 Bulletin 2013/33**

(73) Proprietor: **Enraytek Optoelectronics Co., Ltd.
Shanghai 201203 (CN)**

(72) Inventors:
• **XIAO, Deyuan
  Shanghai 201203 (CN)**

• **CHANG, Richard, Rugin
  Shanghai 201203 (CN)**

(74) Representative: **Viering, Jentschura & Partner
mbB
Patent- und Rechtsanwälte
Grillparzerstrasse 14
81675 München (DE)**

(56) References cited:
**CN-A- 1 753 197          CN-A- 101 075 652
CN-A- 101 075 652        KR-A- 20080 010 225
US-A1- 2006 273 334      US-A1- 2007 018 187
US-A1- 2008 157 110      US-B1- 6 495 862**

EP 2 626 916 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to the light emitting field, and more particularly, to a light emitting diode and its fabrication method.

Background Art

Light Emitting Diode (LED), having the advantages of long service life, low energy consumption and others, is widely used in various fields. In particular, with the greatly improved lighting performance, LED is often used as a light emitting device in lighting field. Wherein, the group III-V compound semiconductors such as gallium nitride (GaN), has tremendous application potential in high-brightness blue LED, blue laser and other photoelectric devices due to its wide band gap, high light emitting efficiency, high electronic saturation drift velocity, stable chemical property and other characteristics, which has aroused wide attention.

However, those semiconductor LEDs in the prior art have the problem of low light emitting efficiency. For a conventional LED without packaging, the light extraction efficiency is generally several percent, because a large amount of energy gathers in the device and fails to give out, thus causing energy waste and also affecting the service life of the device. Therefore, to improve the light extraction efficiency of a semiconductor LED is of vital importance.

Based on the abovementioned application demands, many methods for increasing the light extraction efficiency of an LED are applied to the devices, for instance: surface roughening and metal reflector structures.

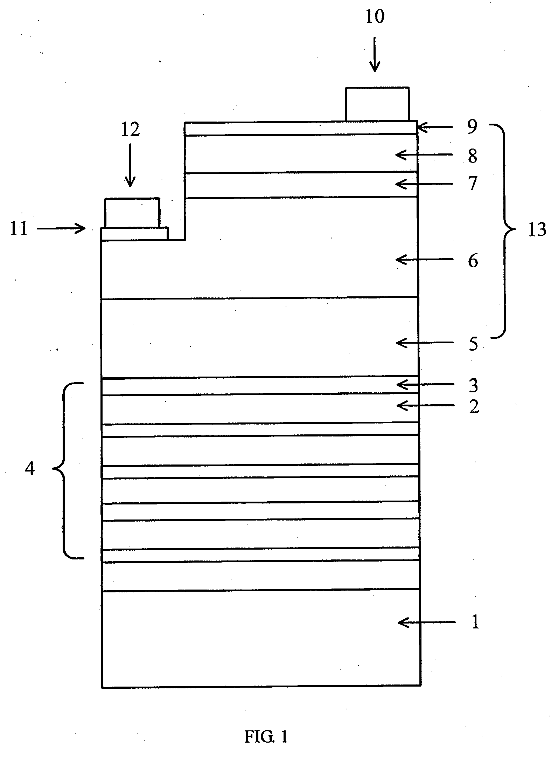

CN 1858918A discloses a GaN-based LED with an omnidirectional reflector structure and its fabrication method. According to FIG. 1, the LED comprises: a substrate 1, an omnidirectional reflector 4 grown on the substrate 1, and a GaN LED chip 13 fabricated on the omnidirectional reflector 4. The GaN LED chip 13 includes: a sapphire substrate 5, an N type GaN layer 6, an active region quantum well layer 7, a P type GaN layer 8, a P type electrode 9, a P type soldering pad 10, an N type electrode 11, and an N type soldering pad 12; wherein the omnidirectional reflector 4 grown on the substrate 1 is stacked by high refractive index layers 3 and low refractive index layers 2, the high refractive index layer 3 is in contact with the sapphire substrate 5, the low refractive index layer 2 is in contact with the substrate 1, the refractive index of the high refractive index layer nH > the refractive index of the low refractive index layer nL > the refractive index of the sapphire material n, and satisfies the formula of $\sin^{-1}\frac{n}{nH} < \tan^{-1}\frac{nL}{nH}$, wherein n, nH and nL represent refractive index. This patent forms an omnidirectional reflector structure on the bottom surface of the LED chip to reflect the light emitted by GaN material at a high refractive index upwards within the omnidirectional range so as to improve the light extraction efficiency of the LED. However, the fabrication process of the LED requires the forming of a film structure stacked by multiple high refractive index layers and low refractive index layers on the substrate, which is a complicated technique and is unfavourable to put into application.

Other methods for increasing light extraction efficiency of an LED include the formation of uneven patterns on a surface of the substrate by using, for example, reactive ion etching (RIE) process. Such uneven patterns may be hemispherical projections as disclosed in US2006/273334A1, or may be hemispherical structures with a plurality of fine protuberances as disclosed in US2007/018187A1, or may be cone-shaped structures as disclosed in EP2461375A1. The formation of such uneven patterns on the substrate can improve the light extraction efficiency to a certain extent, but still cannot meet the requirements for high performance LEDs.

Summary of the Invention

The present invention aims at providing a fabrication method of light emitting diode with simple process and improves the light extraction efficiency of light emitting diodes.

To solve the abovementioned technical problems, the present invention provides a fabrication method of light emitting diode, which comprises: providing a substrate; forming an epitaxial layer, an active layer and a capping layer on the substrate in sequence; and etching the substrate to form a plurality of bifocal micro lens structures on the surface of the substrate away from the epitaxial layer, wherein the step of etching the substrate comprises: forming a plurality of cylindrical photoresist blocks on the surface of the substrate away from the epitaxial layer; baking the cylindrical photoresist blocks to turn the cylindrical photoresist blocks into spherical-crown photoresists; performing in sequence a first and a second inductive coupled plasma etch process by using the spherical-crown photoresists as mask, wherein the coil power of the second inductive coupled plasma etch process is lower than the coil power of the first inductive coupled plasma etch process.

Furthermore, in the fabrication method of light emitting diode, in the first inductive coupled plasma etch process, the coil power is 300W~500W; in the second inductive coupled plasma etch process, the coil power is 270W~450W.

Furthermore, in the fabrication method of light emitting diode, in the first and the second inductive coupled plasma etch processes, the etching gas is a mixture of boron trichloride, helium gas and argon gas, the cavity pressure is 50mTorr~2Torr, the plate power is 200W~300W.

Furthermore, in the fabrication method of light emitting diode, the cylindrical photoresist blocks are baked under a temperature of 120°C~250°C, to turn the cylindrical photoresist blocks into spherical-crown photoresists.

Furthermore, in the fabrication method of light emitting diode, the material of the epitaxial layer is N-doped gallium nitride; the active layer comprises a multiple -quantum-well active layer, the material of the multiple-quantum-well active layer is indium-gallium nitride; the material of the capping layer is P-doped gallium nitride.

Furthermore, in the fabrication method of light emitting diode, before the formation of the epitaxial layer, further comprises: growing a gallium nitride film on the substrate to form a buffer layer.

Furthermore, in the fabrication method of light emitting diode, after the formation of the capping layer, further comprises: forming a transparent conductive layer on the capping layer.

Furthermore, in the fabrication method of light emitting diode, after the formation of the transparent conductive layer, further comprises: forming a first electrode on the transparent conductive layer; forming an opening passing through the transparent conductive layer, the capping layer and the active layer; forming a second electrode in the opening.

Furthermore, in the fabrication method of light emitting diode, after forming the second electrode in the opening, further comprises: forming a passivation layer on the transparent conductive layer to cover the first electrode and the second electrode.

Furthermore, in the fabrication method of light emitting diode, further comprises: reducing the thickness of the substrate before etching the substrate.

With the adoption of the technical solution above, compared with the prior art, the present invention has the following advantages:

The substrate of the LED has a plurality of bifocal microlens structures on the surface away from the epitaxial layer. When the light from the active layer passes through the surfaces of the bifocal microlens structures, the incident angle is always smaller than the critical angle of total reflection so as to prevent total reflection and make sure most of the light pass through the surfaces of the bifocal microlens structures, in this way improving the external quantum efficiency of the LED, increasing the light extraction efficiency of the LED, avoiding the rising of the internal temperature of the LED and improving the performance of the LED.

Brief Description of the Drawings

FIG. 1 is a schematic view of the LED in the prior art;
FIG. 2 is a schematic view of the LED according to one embodiment of the present invention;
FIG. 3 is a flow chart of the fabrication method of LED according to one embodiment of the present invention;
FIG. 4A~4I are sectional views of the fabrication method of LED according to one embodiment of the present invention;
FIG. 5 is a top view of the cylindrical photoresist blocks according to one embodiment of the present invention.

Detailed Description of Preferred Embodiments

To make the abovementioned purposes, features and merits of the present invention clearer and easier to understand, the present invention is further detailed by embodiments in combination with the drawings.

The core spirit of the present invention is to provide an LED and its fabrication method, wherein the substrate of the LED has a plurality of bifocal microlens structures on the surface away from the epitaxial layer. When the light emitted from the active layer passes through the surfaces of the bifocal microlens structures, the incident angle is always smaller than the critical angle of total reflection so as to prevent total reflection and make sure most of the light pass through the surfaces of the bifocal microlens structures, in this way improving the external quantum efficiency of the LED, increasing the light extraction efficiency of the LED, avoiding the rising of the internal temperature of the LED and improving the performance of the LED.

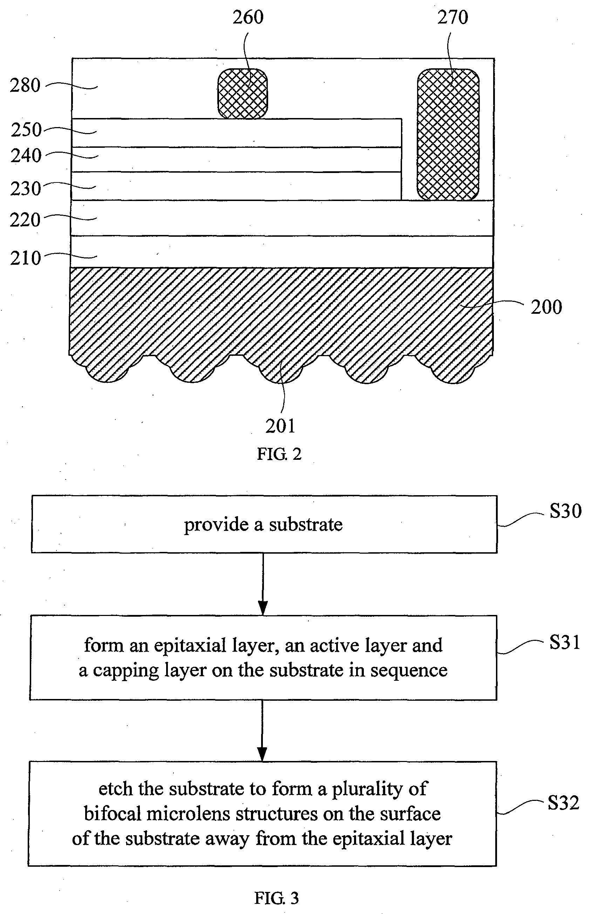

FIG. 2 shows a schematic view of the light emitting diode (LED) according to one embodiment of the present invention. The LED is a light emitting diode with sapphire as the substrate. The LED is a gallium nitride (GaN)-based LED. As shown in FIG. 2, the LED comprises: a substrate 200 as well as an epitaxial layer 220, an active layer 230 and a capping layer 240 arranged on the substrate 200 in sequence, wherein the substrate 200 of the LED has a plurality of bifocal microlens structures 201 on the surface away from the epitaxial layer 220.

In this embodiment, the bifocal microlens structure 201 is composed of two parts. The bottom part (the part directly connecting to the surface of the substrate 200 away from the eptaxial layer 220) is a structure of circular truncated cone with a larger diameter; the top part is a structure of circular truncated cone with a smaller diameter. The bifocal microlens structures 201 can modify the critical angle of total reflection. When the light emitted from the active layer 230 passes through the surfaces of the bifocal microlens structures 201, the incident angle is always smaller than the critical angle of total reflection so as to prevent total reflection and make sure most of the light pass through the surfaces of the bifocal microlens structures 201, in this way improving external quantum efficiency of the LED, avoiding the rise of the internal temperature of the LED and improving the performance of the LED.

In this embodiment, sapphire is selected to be the substrate 200. It shall be known that the substrate 200 can also be made of silicon carbide or gallium nitride.

Furthermore, the LED further comprises a buffer layer 210 which is between the substrate 200 and the epitaxial layer 220 (the bifocal microlens structures 201 are not in contact with the buffer layer 210), wherein the buffer layer 210 can further solve the problem of lattice constant mismatch between the substrate 200 and gallium nitride material. The buffer layer 210 generally adopts gallium nitride film grown under low temperature.

The epitaxial layer 220, the active layer 230 and the capping layer 240 are arranged on the substrate 200 or the buffer layer 210 in sequence, wherein the epitaxial layer 220, the active layer 230 and the capping layer 240 form the tube core of the LED. The epitaxial layer 220 is made of N-doped gallium nitride (n-GaN); the active layer 230 includes a multiple-quantum-well active layer, wherein the multiple -quantum-well active layer is made of indium-gallium nitride (InGaN) to emit blue light with wave length of 470nm; the capping layer 240 is made of P-doped gallium nitride (p-GaN). Since the epitaxial layer 220 and the capping layer 240 are oppositely doped, the N-doped gallium nitride is driven by an external voltage to make electrons drift, while the P-doped gallium nitride is driven by the external voltage to make holes drift, the holes and the electrons are mutually combined in the multiple-quantum-well active layer (also known as active layer) so as to emit light.

Furthermore, the LED further comprises a transparent conductive layer (TCL) 250, wherein the transparent conductive layer 250 is on the capping layer 240. Since the P-doped gallium nitride has a low electric conductivity, a current spreading metal layer, namely the transparent conductive layer 250, is deposited on the surface of the capping layer 240 to raise the electric conductivity. The transparent conductive layer 250 can be made of such materials as nickel/gold (Ni/Au).

In addition, since the substrate 200 does not conduct electricity, in order to connect the tube core of the LED to the positive and negative terminals of the power, the LED further comprises a first electrode 260, a second electrode 270, and an opening passing through the transparent conductive layer 250, the capping layer 240 and the active layer 230; wherein the first electrode 260 is on the transparent conductive layer 250 to connect the transparent conductive layer 250 to the positive terminal of the power; the second electrode 270 is in the opening to connect the epitaxial layer 220 to the negative terminal of the power.

When the LED is used for light emitting, the first electrode 260 is connected to the positive terminal of the power, the second electrode 270 is connected to the negative terminal of the power, the tube core of the LED is connected to the positive terminal of the power via the first electrode 260, and is connected to the negative terminal of the power via the second electrode 270. The active layer 230 in the tube core of the LED emits light under force of current, the bifocal microlens structures 201 make sure that most of the light pass through the surfaces of the bifocal microlens structures 201, in this way improving external quantum efficiency of the LED, avoiding the rise of the internal temperature of the LED and improving the performance of the LED.

Furthermore, the LED further comprises a passivation layer 280 on the transparent conductive layer 250, wherein the passivation layer 280 covers the first electrode 260, the second electrode 270 and the transparent conductive layer 250, and is filled into the opening, to protect the tube core of the LED from damage.

Correspondingly, the present invention further provides a fabrication method of LED, as shown in FIG. 3, which is a flow chart of the fabrication method of LED according to one embodiment of the present invention. The fabrication method of LED comprises the following steps:

S30, provide a substrate;

S31, form an epitaxial layer, an active layer and a capping layer on the substrate in sequence;

S32, etch the substrate to form a plurality of bifocal microlens structures on the surface of the substrate away from the epitaxial layer.

The fabrication method of LED of the present invention will be further detailed in combination with the sectional views, which show a preferred embodiment of the present invention. It shall be understood that those skilled in the art may make changes while still realize the favorable effects of the invention based on this description. Therefore, the description below shall be understood as widely known by those skilled in the art rather than the limitation to the present invention.

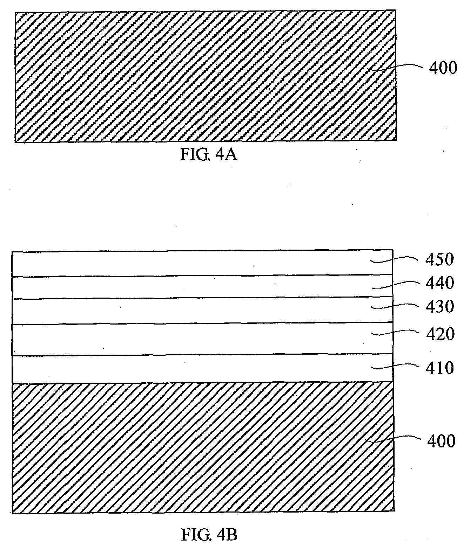

Refer to FIG. 4A, firstly provide a substrate 400, wherein the substrate 400 is a sapphire substrate made of $Al_2O_3$. According to this embodiment, the substrate 400 is used to form a gallium nitride based blue LED.

Refer to FIG. 4B, in order to solve the problem of lattice constant mismatch between the substrate 400 and gallium nitride material, then, form a buffer layer 410 on the substrate 400, wherein the buffer layer 410 generally adopts gallium nitride film grown under low temperature.

After the formation of the buffer layer 410, form an epitaxial layer 420, an active layer 430 and a capping layer 440 on the buffer layer 410 in sequence, wherein the epitaxial layer 420, the active layer 430 and the capping layer 440 constitute the tube core of the LED. The epitaxial layer 420 is made of N-doped gallium nitride; the active layer 430 includes a multiple-quantum-well active layer, wherein the multiple -quantum-well active layer is made of indium-gallium nitride; the capping layer 440 is made of P-doped gallium nitride.

After the formation of the capping layer 440, form a transparent conductive layer 450 on the capping layer 440. The transparent conductive layer 450 is used to raise the electric conductivity. The transparent conductive layer 450 can be made of Ni/Au. The buffer layer 410, the epitaxial layer 420, the active layer 430 and the capping layer 440 can be formed by means of conventional metal organic chemical vapor deposition (MOCVD) process; the transparent conductive layer 450 can be formed by means of physical vapor deposition (PVD) process.

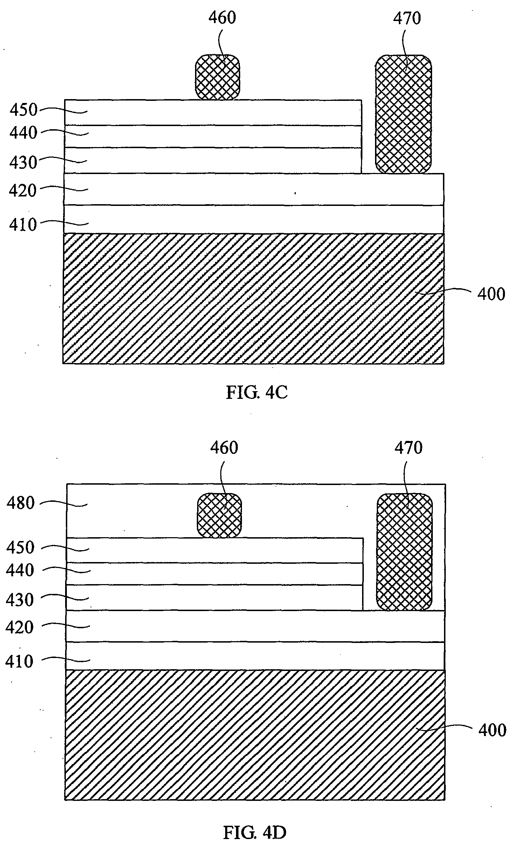

Refer to FIG. 4C, afterwards, form a first electrode 460 on the transparent conductive layer 450 to connect the transparent conductive layer 450 to the positive terminal of the power; and then form an opening passing through the transparent conductive layer 450, the capping layer 440 and the active layer 430 by means of photolithography and etch, after that, form a second electrode 470 in the opening to connect the epitaxial layer 420 to the negative terminal of the power. Preferably, the upper surfaces of the first electrode 460 and the second electrode 470 are on the same level. In other embodiments, the opening can also be extended into the epitaxial layer 420, in other words, the opening can also pass through part of the thickness of the epitaxial layer 420.

Refer to FIG. 4D, next, form a passivation layer 480 on the transparent conductive layer 450, wherein the passivation layer 480 covers the first electrode 460, the second electrode 470, the transparent conductive layer 450, and is filled into the opening. The passivation layer 480 is used to protect the tube core of the LED from damage.

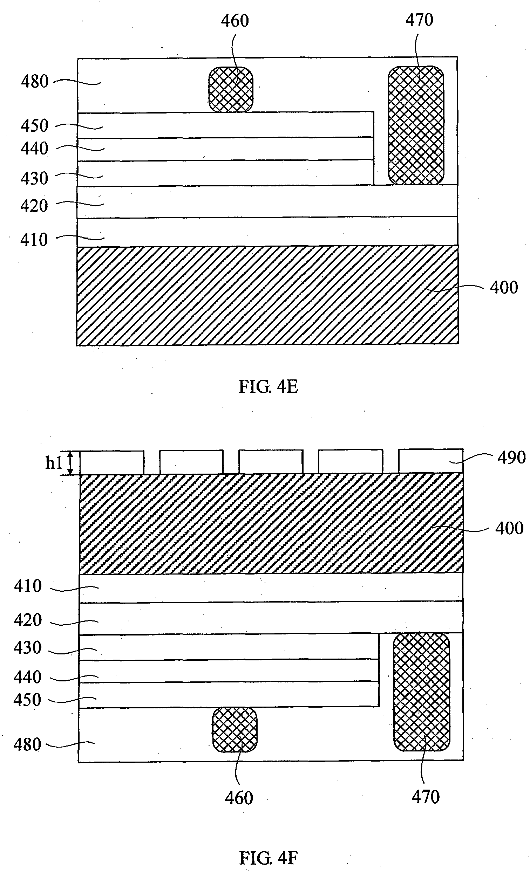

Refer to FIG. 4E, afterwards, reduce the thickness of the substrate 400. The thinning of the substrate 400 can be realized by backside grinding or laser liftoff (LTO) process. In this embodiment, the substrate 400 is thinned to $10\sim100\mu m$.

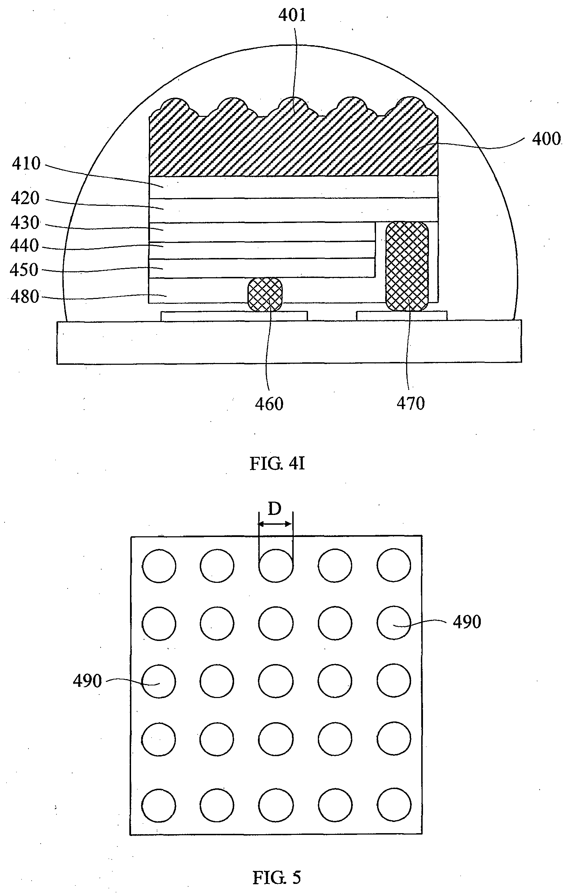

Refer to FIG. 4F, next, turn over the substrate 400 after thinning to bring the side of the substrate 400 away from the epitaxial layer 420 (the side without contacting the buffer layer 410) upward, and then form a plurality of cylindrical photoresist blocks 490 arranged in array on the substrate 400 by photoresist coating, exposing and developing processes. Refer to FIG. 5, a cylindrical photoresist block 490 refers to a photoresist block whose vertical view (parallel to the surface of the substrate 400) is round-shaped. Alternatively, the cylindrical photoresist blocks 490 have a thickness h1 of $0.1\mu m\sim5\mu m$ and a diameter D of $1\mu m\sim10\mu m$, and the spacing between adjacent blocks 490 is $0.1\mu m\sim1\mu m$. It shall be understood that those skilled in the art may adjust the dimensions of the cylindrical photoresist blocks 490 according to the desired size of the bifocal microlens structures.

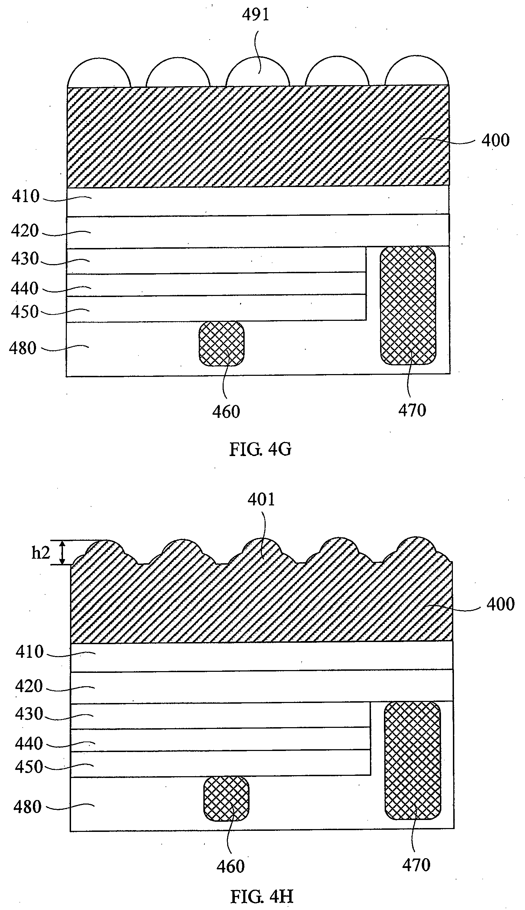

Refer to FIG. 4G, afterwards, bake the cylindrical photoresist blocks 490 to turn the cylindrical photoresist blocks 490 into spherical-crown photoresists 491. In this embodiment, the cylindrical photoresist blocks 490 are baked under the temperature of 120°C~250°C. The cylindrical photoresist blocks 490 become spherical-crown photoresists 491 under force of surface tension at a temperature higher than the glass melting temperature of the photoresist. In other embodiments, the cylindrical photoresist blocks 490 can also be baked under other temperatures.

Refer to FIG. 4H, next, perform twice the inductive coupled plasma (ICP) etch process by using the spherical-crown photoresists 491 as mask until the spherical-crown photoresists 491 are completely etched so as to form a plurality of bifocal microlens structures 401 on the surface of the substrate 400 away from the epitaxial layer 420.

In this embodiment, perform in sequence a first inductive coupled plasma etch process and a second inductive coupled plasma etch process, wherein, the coil power of the second inductive coupled plasma etch process is lower than the coil power of the first inductive coupled plasma etch process, so as to form bifocal microlens structures with a smaller diameter at the top and a larger diameter at the bottom. The height h2 of the bifocal microlens structures 401 can be $3\mu m\sim5\mu m$. It is acceptable to adjust the height of the bifocal microlens structures 401 according to the requirements of the corresponding devices.

Alternatively, in the first inductive coupled plasma etch process, firstly etch part of the spherical-crown photoresists 491. The etching gas can be a mixture of boron trichloride ($BCl_3$), helium gas (He) and argon gas (Ar), wherein the flow rate of boron trichloride can be, for example, 20~1000sccm; the flow rate of helium gas can be, for example, 20~500sccm; the flow rate of argon gas can be, for example, 20~500sccm; the cavity pressure is 50mTorr~2Torr, the plate power is 200W~300W and the coil power is 300W~500W.

Alternatively, in the second inductive coupled plasma etch process, etch the remaining spherical-crown photoresists 491. The etching gas is the same as in the first inductive coupled plasma etch process, the cavity pressure is kept unchanged, and the plate power is also kept uncharged, only the coil power is changed, so that the coil power of the second inductive coupled plasma etch process is lower than the coil power of the first inductive coupled plasma etch process, for example 270W~450W.

The top diameter and bottom diameter of the bifocal microlens structures can be adjusted by changing the coil powers of the first and second inductive coupled plasma etch processes; the heights of the two parts (top part, bottom part) of the bifocal microlens structures can be adjusted by changing the etching time of the first and second inductive coupled plasma etch processes.

It shall be noted that the description above does not constitute limitation to the present invention. Those skilled in the art may regulate the etching gas and various technical parameters as well as the etching selection ratio according to the real-life conditions of the etching machine so as to form bifocal microlens structures on the substrate.

Refer to FIG. 4I, after the formation of the bifocal microlens structures 401 by etching the substrate, part of the thickness of the passivation layer 480 can be removed by etching back the passivation layer 480 via traditional etch back process, and then the LED can be packaged by conventional dicing and bumping packaging process to form LED packages. The present invention does not relate to the improvement of the packaging process, so details are not given herein anymore, but those skilled in the art shall know about this.

It shall be noted that, the blue LED in the abovementioned embodiment is taken as an example, but this does not constitute limitation to the present invention, the above embodiment can also be applied to red LED, yellow LED. Those skilled in the art may make modification, replacement and deformation to the present invention according to the embodiment above.

To sum up, the present invention provides an LED and its fabrication method, wherein the substrate of the LED has a plurality of bifocal microlens structures on the surface away from the epitaxial layer. When the light emitted from the active layer passes through the surfaces of the bifocal microlens structures, the incident angle is always smaller than the critical angle of total reflection so as to prevent total reflection and make sure most of the light pass through the surfaces of the bifocal microlens structures, in this way improving external quantum efficiency of the LED, increasing the light extraction efficiency of the LED, avoiding the rise of the internal temperature of the LED and improving the performance of the LED. Compared with the prior art, the present invention has simpler LED manufacturing process and lower manufacturing cost.

It is clear that those skilled in the art may make various changes and deformations. If such changes and deformations are within the scope of the claims and the equivalent technological scope, the present invention is also intended to include these changes and deformations.

**Claims**

1. A fabrication method of light emitting diode, comprising:

   providing a substrate (400);
   forming an epitaxial layer (420), an active layer (430) and a capping layer (440) on the substrate (400) in sequence;
   etching the substrate (400) to form a plurality of bifocal microlens structures (401) on the surface of the substrate (400) away from the epitaxial layer (420), **characterized in that**, the step of etching the substrate (400) comprises:

      forming a plurality of cylindrical photoresist blocks (490) on the surface of the substrate (400) away from the epitaxial layer (420);
   baking the cylindrical photoresist blocks (490) to turn the cylindrical photoresist blocks (490) into spherical-crown photoresists (491);
   performing in sequence a first and a second inductive coupled plasma etch process by using the spherical-crown photoresists (491) as mask, wherein, the coil power of the second inductive coupled plasma etch process is lower than the coil power of the first inductive coupled plasma etch process.

2. The fabrication method as claimed in claim 1, **characterized in that**, in the first inductive coupled plasma etch process, the coil power is 300W~500W; in the second inductive coupled plasma etch process, the coil power is 270W~450W.

3. The fabrication method as claimed in claim 2, **characterized in that**, in the first and the second inductive coupled plasma etch processes, the etching gas is a mixture of boron trichloride, helium gas and argon gas, the cavity pressure being 50mTorr~2Torr, the plate power being 200W~300W.

4. The fabrication method as claimed in claim 1, **characterized in that**, the cylindrical photoresist blocks (490) are baked under a temperature of 120°C~250°C to turn the cylindrical photoresist blocks (490) into spherical-crown photoresists (491).

5. The fabrication method as claimed in any one of claims 1~4, further comprising growing a gallium nitride film on the substrate (400) to form a buffer layer (410) before the formation of the epitaxial layer (420).

6. The fabrication method as claimed in any one of claims 1~4, further comprising forming a transparent conductive layer (450) on the capping layer (440) after the formation of the capping layer (440).

7. The fabrication method as claimed in claim 6, **characterized in that**, after the formation of the transparent conductive layer (450), further comprising:

   forming a first electrode (460) on the transparent conductive layer (450);
   forming an opening passing through the transparent conductive layer (450), the capping layer (440) and the active layer (430);
   forming a second electrode (470) in the opening.

8. The fabrication method as claimed in claim 7, **characterized in that**, after forming the second electrode (470) in the opening, further comprising:

forming a passivation layer (480) on the transparent conductive layer (450) to cover the first electrode (460) and the second electrode (470).

9. The fabrication method as claimed in any one of claims 1~4, further comprising reducing the thickness of the substrate (400) before etching the substrate (400).

**Patentansprüche**

1. Ein Herstellungsverfahren für eine lichtemittierende Diode aufweisend:

   Bereitstellen eines Substrats (400),
   Bilden einer Epitaxialschicht (420), einer Aktivschicht (430) und einer Capping-Schicht (440) nacheinander auf dem Substrat (400),
   Ätzen des Substrats (400), um eine Mehrzahl bifokaler Mikrolinsen-Strukturen (401) auf der Oberfläche des Substrats (400) im Abstand von der Epitaxialschicht (420) zu bilden, **dadurch gekennzeichnet, dass** der Schritt des Ätzens des Substrats (400) aufweist:

   Bilden einer Mehrzahl zylindrischer Fotolackblöcke (490) auf der Oberfläche des Substrats (400) im Abstand zu der Epitaxialschicht (420),
   Backen der zylindrischen Fotolackblöcke (490), um die zylindrischen Fotolackblöcke (490) in Kugelkronen-Fotolacke (491) umzuwandeln,
   Durchführen, nacheinander, eines ersten und eines zweiten induktiven gekoppelten Plasma-Ätzprozesses unter Verwendung der Kugelkronen-Fotolacke (491) als Maske, wobei die Spulenleistung des zweiten induktiven gekoppelten Plasma-Ätzprozesses niedriger ist als die Spulenleistung des ersten induktiven gekoppelten Plasma-Ätzprozesses.

2. Das Herstellungsverfahren gemäß Anspruch 1, **dadurch gekennzeichnet, dass** in dem ersten induktiven gekoppelten Plasma-Ätzprozess die Spulenleistung 300W~500W beträgt und in dem zweiten induktiven gekoppelten Plasma-Ätzprozess die Spulenleistung 270W~450W beträgt.

3. Das Herstellungsverfahren gemäß Anspruch 2, **dadurch gekennzeichnet, dass** in dem ersten und in dem zweiten induktiven gekoppelten Plasma-Ätzprozess das Ätzgas eine Mischung aus Bortrichlorid, Heliumgas und Argongas ist, wobei der Forminnendruck 50mTorr~2Torr beträgt und die Plattenleistung 200W~300W beträgt.

4. Das Herstellungsverfahren gemäß Anspruch 1, **dadurch gekennzeichnet, dass** die zylindrischen Fotolackblöcke (490) bei einer Temperatur von 120°C~250°C gebacken werden, um die zylindrischen Fotolackblöcke (490) in Kugelkronen-Fotolacke (491) umzuwandeln.

5. Das Herstellungsverfahren gemäß irgendeinem der Ansprüche 1 bis 4, ferner aufweisend das Wachsen eines Galliumnitrid-Films auf dem Substrat (400), um eine Pufferschicht (410) zu bilden, bevor die Epitaxialschicht (420) gebildet wird.

6. Das Herstellungsverfahren gemäß irgendeinem der Ansprüche 1 bis 4, ferner aufweisend das Bilden einer transparenten Leiterschicht (450) auf der Capping-Schicht (440) nachdem die Capping-Schicht (440) gebildet wurde.

7. Das Herstellungsverfahren gemäß Anspruch 6, **dadurch gekennzeichnet, dass** das Verfahren nach dem Bilden der transparenten Leiterschicht (450) ferner aufweist:

   Bilden einer ersten Elektrode (460) auf der transparenten Leiterschicht (450),
   Bilden einer Öffnung, welche durch die transparente Leiterschicht (450), die Capping-Schicht (440) und die Aktivschicht (430) verläuft,
   Bilden einer zweiten Elektrode (470) in der Öffnung.

8. Das Herstellungsverfahren gemäß Anspruch 7, **dadurch gekennzeichnet, dass** das Verfahren nach dem Bilden der zweiten Elektrode (470) in der Öffnung ferner aufweist:

   Bilden einer Passivierungsschicht (480) auf der transparenten Leiterschicht (450), um die erste Elektrode (460) und die zweite Elektrode (470) abzudecken.

9. Das Herstellungsverfahren gemäß irgendeinem der Ansprüche 1 bis 4, ferner aufweisend ein Reduzieren der Dicke des Substrats (400) vor dem Ätzen des Substrats (400).

**Revendications**

1. Procédé de fabrication d'une diode électroluminescente, comprenant les étapes consistant à :

   - fournir un substrat (400) ;
   - former une couche épitaxiale (420), une couche active (430) et une couche d'encapsulation (440) sur le substrat (400) dans cet ordre ;
   - graver le substrat (400) de façon à former une pluralité de structures de microlentilles bifocales (401) sur la surface du substrat (400) en s'éloignant de la couche épitaxiale (420), **caractérisé en ce que** l'étape consistant à graver le substrat (400) comprend les étapes consistant à :

- former une pluralité de blocs cylindriques de résine photosensible (490) sur la surface du substrat (400) en s'éloignant de la couche épitaxiale (420) ;
- cuire les blocs cylindriques de résine photosensible (490) de façon à transformer les blocs cylindriques de résine photosensible (490) en calottes sphériques de résine photosensible (491) ;
- exécuter dans l'ordre des premier et second processus de gravure par plasma à couplage inductif en utilisant les calottes sphériques de résine photosensible (491) en tant que masque, dans lequel, la puissance bobine du second processus de gravure par plasma à couplage inductif est inférieure à la puissance bobine du premier processus de gravure par plasma à couplage inductif.

2. Procédé de fabrication selon la revendication 1, **caractérisé en ce que**, dans le premier processus de gravure par plasma à couplage inductif, la puissance bobine est comprise entre 300 W et 500 W ; dans le second processus de gravure par plasma à couplage inductif, la puissance bobine est comprise entre 270 W et 450 W.

3. Procédé de fabrication selon la revendication 2, **caractérisé en ce que**, dans les premier et second processus de gravure par plasma à couplage inductif, le gaz de gravure est un mélange de trichlorure de bore, de gaz hélium et de gaz argon, la pression dans la cavité étant comprise entre 50 mTorr et 2 Torr, la puissance plaque étant comprise entre 200 W et 300 W.

4. Procédé de fabrication selon la revendication 1, **caractérisé en ce que**, les blocs cylindriques de résine photosensible (490) sont cuits à une température comprise entre 120 °C et 250 °C de façon à transformer les blocs cylindriques de résine photosensible (490) en calottes sphériques de résine photosensible (491).

5. Procédé de fabrication selon l'une quelconque des revendications 1 à 4, comprenant en outre une étape consistant à tirer une couche de nitrure de gallium sur le substrat (400) de façon à former une couche tampon (410) avant la formation de la couche épitaxiale (420).

6. Procédé de fabrication selon l'une quelconque des revendications 1 à 4, comprenant en outre une étape consistant à former une couche conductrice transparente (450) sur la couche d'encapsulation (440) après la formation de la couche d'encapsulation (440).

7. Procédé de fabrication selon la revendication 6, **caractérisé en ce qu'**il comprend en outre, après la formation de la couche conductrice transparente (450), les étapes consistant à :

- former une première électrode (460) sur la couche conductrice transparente (450) ;
- former une ouverture qui passe à travers la couche conductrice transparente (450), la couche d'encapsulation (440) et la couche active (430) ;
- former une seconde électrode (470) dans l'ouverture.

8. Procédé de fabrication selon la revendication 7, **caractérisé en ce qu'**il comprend en outre, après la formation de la seconde électrode (470) dans l'ouverture, une étape consistant à :

- former une couche de passivation (480) sur la couche conductrice transparente (450) de façon à couvrir la première électrode (460) et la seconde électrode (470).

9. Procédé de fabrication selon l'une quelconque des revendications 1 à 4, comprenant en outre une étape consistant à réduire l'épaisseur du substrat (400) avant de graver le substrat (400).

FIG. 1

280

250
240
230

220

210

260

270

200

201

FIG. 2

provide a substrate — S30

form an epitaxial layer, an active layer and
a capping layer on the substrate in sequence — S31

etch the substrate to form a plurality of
bifocal microlens structures on the surface
of the substrate away from the epitaxial layer — S32

FIG. 3

400

FIG. 4A

450

440

430

420

410

400

FIG. 4B

460    470

450
440
430
420
410

400

FIG. 4C

460    470

480

450
440
430
420
410

400

FIG. 4D

480

460

470

450
440
430
420
410

400

FIG. 4E

h1

490

400

410

420

430

440

450

480

460

470

FIG. 4F

491

400

410

420

430

440

450

480

460          470

FIG. 4G

401

h2

400

410

420

430

440

450

480

460          470

FIG. 4H

401

400

410

420

430

440

450

480

460          470

FIG. 4I

D

490

490

FIG. 5

**EP 2 626 916 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 1858918 A
- US 2006273334 A1
- US 2007018187 A1
- EP 2461375 A1